(19) Europäisches Patentamt
European Patent Office
Office européen des brevets

(11) **EP 2 619 815 B1**

(12) **EUROPÄISCHE PATENTSCHRIFT**

(45) Veröffentlichungstag und Bekanntmachung des Hinweises auf die Patenterteilung:
**15.04.2015 Patentblatt 2015/16**

(21) Anmeldenummer: **11766917.6**

(22) Anmeldetag: **20.09.2011**

(51) Int Cl.:
*H01L 51/52* *(2006.01)*      *H01L 51/50* *(2006.01)*
*H01L 51/56* *(2006.01)*

(86) Internationale Anmeldenummer:
**PCT/EP2011/066261**

(87) Internationale Veröffentlichungsnummer:
**WO 2012/038389 (29.03.2012 Gazette 2012/13)**

(54) **LADUNGSTRÄGERMODULATION ZUR FARB- UND HELLIGKEITSABSTIMMUNG IN ORGANISCHEN LEUCHTDIODEN**

CHARGE CARRIER MODULATION FOR COLOR AND BRIGHTNESS COORDINATION IN ORGANIC LIGHT-EMITTING DIODES

MODULATION DE PORTEUR DE CHARGE POUR UNE SYNTONISATION DE LA COULEUR ET DE LA LUMINOSITÉ DANS DES DIODES ÉLECTROLUMINESCENTES ORGANIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.09.2010 DE 102010041331**

(43) Veröffentlichungstag der Anmeldung:
**31.07.2013 Patentblatt 2013/31**

(73) Patentinhaber: **Siemens Aktiengesellschaft 80333 München (DE)**

(72) Erfinder:
• **SCHMID, Günter 91334 Hemhofen (DE)**
• **TAROATA, Dan 91054 Erlangen (DE)**

(56) Entgegenhaltungen:
**EP-A2- 1 531 501        EP-A2- 1 748 505
EP-A2- 1 978 574        WO-A2-03/100880
US-A1- 2007 096 644        US-A1- 2009 230 384**

**Beschreibung**

Die vorliegende Erfindung betrifft organische Halbleiterbauelemente und deren Herstellung.

Im Bereich der organischen Halbleiter ist bekannt, dass zum Transport von Elektronen als Ladungsträger Elektronentransportschichten und zum Transport von Löchern als Ladungsträger Lochtransportschichten eingesetzt werden müssen. In Bauteilen, in denen beide Ladungsträger zum Einsatz kommen, z.B. in Diodenstrukturen, wird der Loch- oder Elektronenstrom durch die Schichtdicke der jeweiligen Transportschichten oder durch die Dotierung der jeweiligen Transportschichten beeinflusst. Alternativ oder zusätzlich können geeignete Elektronen- oder Lochinjektionsschichten der Transportschicht vorgeschaltet werden. Für die Verhinderung oder Minimierung eines Transports einer Ladungsträgersorte können auch Loch oder Elektronen blockende Barriereschichten eingesetzt werden.

Die Druckschriften EP 1978574 A, US 2007/096644 A, EP 1531501 A und EP 1748505 A offenbaren jeweils ein Elektrolumineszenzelement in Form einer Diode mit einer organischen Leuchtschicht zwischen Anode und Kathode.

Eine organische Leuchtdiode ist ein Beispiel aus dem Stand der Technik für eine Diodenstruktur aus organischen Halbleitern. Auch in organischen Feldeffekttransistoren, Solarzellen oder Fotodetektoren stellt sich das Problem der sehr unterschiedlichen Beeinflussung von Elektronen oder Löchern als Ladungsträger durch die genannten Faktoren wie Schichtdicke, Dotierung, Injektions- oder Barriereschichten. In allen diesen organischen Halbleiterbauteilen ist nach deren Herstellung der Anteil von Löchern oder der Anteil von Elektronen am Gesamtstromfluss durch das Bauteil festgelegt.

Es ist Aufgabe der vorliegenden Erfindung, ein Bauelement anzugeben, mittels dem der Ladungsträgerfluss einer Ladungsträgersorte moduliert werden kann.

Die Aufgabe ist durch eine Vorrichtung und ein zugehöriges Herstellungsverfahren gemäß den unabhängigen Patentansprüchen gelöst. Vorteilhafte Ausgestaltungen der Vorrichtung und Weiterbildungen des Herstellungsverfahrens sind Gegenstand der Unteransprüche.

Als Elektronentransporter werden organische Halbleiter bezeichnet, in denen die Mobilität der Elektronen sehr viel höher ist als die der Löcher und daher der Elektronentransport den Hauptstromfluss ausmacht. Als Lochtransporter werden Halbleiter bezeichnet, in denen die Mobilität der Löcher höher ist als die der Elektronen und daher der Lochtransport den Hauptstromfluss ausmacht. Grundsätzlich existieren beide Ladungsträgersorten in dem organischen Halbleiter und werden in Majoritäts- und Minoritätsladungsträger unterschieden.

In einer vorteilhaften Ausgestaltung der Erfindung sind zwischen den aufeinanderliegenden Halbleiterschichten Heteroübergänge ausgebildet. D.h., die Elektronentransportschicht bildet zu der ersten und zweiten Lochtransportschicht je einen Heteroübergang aus sowie die Lochtransportschicht zwischen den Elektronentransportschichten zu diesen je einen Heteroübergang ausbildet. Dies hat den Vorteil einer Realisierung als Dünnschichtbauteil mit niedriger Betriebsspannung.

Die Elektronentransportschicht zwischen der ersten und zweiten Lochtransportschicht und/oder die Lochtransportschicht zwischen der ersten und zweiten Elektronentransportschicht sind als eine Modulationsschicht ausgestaltet. Modulationsschicht heißt dabei, dass diese Schicht für die Modulation der Ladungsträger verantwortlich ist. Dabei werden von der Elektronentransportschicht der Lochtransport von der ersten in die zweite Lochtransportschicht moduliert und von der Lochtransportschicht wird der Elektronentransport von der ersten in die zweite Elektronentransportschicht beeinflusst. Als Modulationsschicht ausgestaltet heißt, dass die Halbleiterschicht einen Kontakt für eine Modulationsspannung aufweist. Mit diesem Kontakt wird durch Anlegen einer Modulationsspannung ein Modulationsstromfluss über die Modulationsschicht erzeugt. Dieser Modulationsstromfluss beeinflusst den Bauteilstromfluss, der von der ersten in die zweite Loch- oder Elektronentransportschicht über die jeweilige Modulationsschicht fließt. Dieser Bauteilstromfluss ist also durch den Modulationsstrom steuerbar. Diese Ausgestaltung hat insbesondere den Vorteil, über eine Modulationsspannung den Stromfluss einer Ladungsträgersorte gegenüber dem Gesamtstromfluss variieren zu können. Der Gesamtstrom setzt sich aus Elektronen- und Lochstrom zusammen.

In einer weiteren vorteilhaften Ausgestaltung der Erfindung weist die Modulationsschicht eine Schichtdicke auf, die geringer ist als die Diffusionslänge der Minoritätsladungsträger in dem Halbleitermaterial der Modulationsschicht. Die Diffusionslänge der Minoritätsladungsträger begrenzt also die Schichtdicke auf eine Maximalschichtdicke. Die Maximalschichtdicke ist über die Diffusionslänge abhängig von der angelegten Spannung. Die Diffusionslänge $L_{diff}$ der Ladungsträger ist nämlich abhängig von der Beweglichkeit $\mu$ der Ladungsträger. Die Beweglichkeit der Ladungsträger in organischen Halbleitermaterialien wiederum ist abhängig von der Feldstärke des elektrischen Feldes, d.h. von der angelegten Spannung und der Schichtdicke.

$$L_{diff} = \sqrt{D \cdot \tau} = \sqrt{\frac{k \cdot T}{q} \cdot \mu \cdot \tau}$$

Dabei ist D der Diffusionskoeffizient, $\tau$ die Lebensdauer, k die Boltzmann-Konstante, T die Temperatur und q die Ladung.

In einer weiteren vorteilhaften Ausgestaltung der Erfindung wird in dem stromgesteuerten Bauelement eine Modulationsspannung so an die Modulationsschicht und an die erste Loch- oder Elektronentransportschicht angelegt, dass die zu steuernden Ladungsträger, die die Majoritätsladungsträger in dem Halbleitermaterial der Transportschichten und die Minoritätsladungsträger in dem Halbleitermaterial der Modulationsschicht sind, von der ersten Transportschicht in die Modulationsschicht bewegt werden. Diese Ausgestaltung hat den Vorteil, dass die eingebrachte Modulationsschicht den Ladungsträgerfluss nicht nur minimiert oder drosselt, sondern diesen auch erhöhen kann. Der Gesamt- oder Bauteil-Ladungsträgerfluss, also der Strom von der ersten in die zweite Transportschicht jeweils über die Modulationsschicht, ist also durch den Modulationsstrom, der über die Modulationsschicht abfließt, steuerbar.

Vorzugsweise sind die Transportschichten dotiert. Insbesondere ist die jeweils erste Transportschicht, die im Ladungsträgerfluss vor der Modulationsschicht liegt, dotiert. Insbesondere beträgt die Dotierkonzentration der Transportschichten, besonders der ersten Transportschicht, zwischen 0,01 Vol-% und 10 Vol-%. Zweckdienlicherweise liegt die Dotierkonzentration einer Transportschicht unter 50 Vol%. Vorzugsweise liegt die Transportschicht unter 20 Vol-%.

Beispielsweise ist die Modulationsschicht dotiert. Insbesondere weist die Modulationsschicht eine Dotierkonzentration zwischen 0,01 Vol-% und 10 Vol-% auf. Zweckdienlicherweise liegt die Dotierkonzentration der Modulationsschicht unter 50 Vol-%. Vorzugsweise liegt die Dotierkonzentration der Modulationsschicht unter 20 Vol-%.

Das erfindungsgemäße stromgesteuerte Bauelement kann vorzugsweise in einer organischen Leuchtdiode eingebracht sein. Dies hat den Vorteil, dass der Loch- und/oder der Elektronenstrom in der organischen Leuchtdiode separat steuerbar ist.

In einer weiteren vorteilhaften Ausgestaltung der Erfindung umfasst die organische Leuchtdiode wenigstens ein vorbeschriebenes stromgesteuertes Bauelement, wobei die Farbwiedergabe der organischen Leuchtdiode durch das Anlegen der Modulationsspannung veränderbar ist. Durch das Anlegen der Modulationsspannung an das Bauelement kann der Lochstrom oder der Elektronenstrom gesteuert werden. Die Farbwiedergabe der organischen Leuchtdiode ist davon abhängig, wieweit Elektronen und/oder Löcher in die Emissionszone der Leuchtdiode eindringen, bevor sie rekombinieren.

In einer besonders vorteilhaften Ausgestaltung der Erfindung umfasst die organische Leuchtdiode wenigstens ein stromgesteuertes Bauelement für die Steuerung des Lochstroms oder für die Steuerung des Elektronenstroms und weist eine Emissionszone aus mindestens zwei Emissionsschichten auf. Die Emissionsschichten emittieren insbesondere Licht unterschiedlicher Farbe. Dies hat den Vorteil, dass durch die Steuerung des Elektronen- oder Lochstroms der Ort der Rekombination in eine der beiden Emissionsschichten verlagert werden kann.

In einer weiteren vorteilhaften Ausgestaltung der Erfindung umfasst die organische Leuchtdiode wenigstens ein stromgesteuertes Bauelement, wobei die Effizienz der organischen Leuchtdiode durch das Anlegen der Modulationsspannung veränderbar ist. Die Effizienz einer Leuchtdiode ergibt sich aus der Lichtemission pro Stromfluss. Dabei ist nicht eine erhöhte Leitfähigkeit durch das Bauteil erforderlich, sondern es kommt auf die Ladungsträgerbalance zwischen Elektronen und Löchern an. Nur wenn sich gleich viele Elektronen und Löcher in der Emissionszone treffen und dort rekombinieren, erhält man eine hohe Effizienz von ausgesendetem Lichtstrom pro elektrischem Stromfluss im Bauteil. Diese Ladungsträgerbalance kann durch ein stromgesteuertes Bauelement mit dem der Stromfluss einer einzelnen Ladungsträgersorte gesteuert werden kann, optimiert werden. Insbesondere sind beidseitig auf der Elektronen- sowie auf der Lochtransportseite zur Emissionsschicht hin je ein stromgesteuertes Bauelement gemäß der Erfindung in die organische Leuchtdiode eingebracht.

In einer weiteren vorteilhaften Ausgestaltung der Erfindung umfasst die organische Leuchtdiode zwei stromgesteuerte Bauelemente. Davon ist insbesondere eines zur Steuerung des Elektronentransports zwischen der Kathode und der Emitterschicht angebracht. Das Bauelement zur Steuerung des Lochtransportes ist insbesondere zwischen der Anode und der Emitterschicht angebracht. Zweckdienlicherweise umfassen die stromgesteuerten Bauelemente drei organische Halbleiterschichten. Diese können als Transportschichten in der organischen Leuchtdiode eingesetzt werden. Insbesondere findet ein stromgesteuertes Bauelement zur Steuerung des Elektronenstroms Einsatz als eine Elektronentransportschicht. Ein stromgesteuertes Bauelement zur Steuerung des Lochstroms kann z.B. als Lochtransportschichten eingesetzt werden. Die Bauelemente umfassen also jeweils geeignete Loch- oder Elektronentransportschichten. Diese sind dann von einer nur sehr dünnen Schicht unterteilt, die für den Transport der jeweils anderen Ladungsträgersorte geeignet ist, also eine Blockierschicht darstellt. Die Schicht ist aber zweckdienlicherweise so dünn, dass die Ladungsträger, die in der Schicht die Minoritätsladungsträger sind, durch diese diffundieren können. D.h. zweckdienlicherweise ist die Schichtdicke der Modulationsschicht geringer als die Diffusionslänge der Minoritätsladungsträger in der Modulationsschicht.

Beispielsweise sind die stromgesteuerten Halbleiterbauelemente zur Ladungsträgermodulation zum Aufbau einer Logik geeignet. Ein Ladungsträgermodulator für Elektronen und/oder einer für Löcher kann zur Abstimmung einer Solarzelle eingesetzt werden. Insbesondere in einer Zusammenschaltung von mehreren organischen Solarzellen, zum Beispiel auf einem Paneel, kann ein stromgesteuertes Bauelement zur Abstimmung der Solarzellen untereinander genutzt werden.

Ein Herstellungsverfahren für ein stromgesteuertes Bauelement umfasst die folgenden Schritte:

Auf eine erste organische Halbleiterschicht wird zunächst eine zweite organische Halbleiterschicht abgeschieden. Darauf wird anschließend eine dritte organische Halbleiterschicht abgeschieden. Die Halbleiterschichten werden insbesondere vertikal aufeinander abgeschieden, d.h. die Halbleiterschichten sind lateral ausgedehnt und werden vertikal aufeinander gestapelt. Dabei werden für die erste und dritte Halbleiterschicht Materialien verwendet, in denen die gleiche Majoritätsladungsträgersorte elektrisch geleitet wird. Für die zweite Halbleiterschicht wird ein Material verwendet, das eine von der ersten und dritten Halbleiterschicht unterschiedliche Majoritätsladungsträgersorte aufweist. D.h. also, wenn die erste und dritte organische Halbleiterschicht Lochleiter sind, wird dazwischen als zweite Halbleiterschicht eine Elektronenleiterschicht angebracht. Wenn die erste und dritte Halbleiterschicht Elektronenleiter sind, wird dazwischen als zweite Halbleiterschicht eine Lochtransportschicht abgeschieden. Die einzelnen Schichten können beispielsweise auch noch jeweils durch eine intrinsische, undotierte organische Halbleiterschicht getrennt werden. Derartige Interlayer können beispielsweise eingebracht werden um die gegenseitige Reaktion der Dopanden zu verhindern und wirken demnach passivierend.

Dieses Verfahren hat den Vorteil, dass die Halbleiterschichten Heteroübergänge ausbilden. Für die Herstellung der Schichten des Bauteils wird kein Strukturierungsverfahren, z.B. ein aufwendiger Lithographieprozess benötigt.

Zeitgleich mit oder direkt nach der Abscheidung der zweiten Halbleiterschicht wird eine elektrische Kontaktierung der zweiten Halbleiterschicht mit einem Kontakt bewirkt. Kontaktierung mit einem Kontakt heißt dabei, dass die zweite Halbleiterschicht trotz ihrer geringen Schichtdicke in dem Halbleiterschichtstapel einen Kontakt aufweist, der extern z.B. von einer Spannungsquelle kontaktiert werden kann. Dieser Kontakt steht nicht in direktem elektrischem Kontakt mit der dritten Halbleiterschicht. Beispielsweise wird die Kontaktierung mit dem Kontakt dadurch erwirkt, dass die zweite Halbleiterschicht durch ein verändertes Schichtlayout abgeschieden wird, insbesondere ein verändertes Schichtlayout gegenüber der ersten und/oder gegenüber der dritten Halbleiterschicht. Der Kontakt mit dem die zweite Halbleiterschicht verbunden wird, ist insbesondere lateral zu dem Schichtstapel angeordnet. Die Kontaktierung erfolgt insbesondere so, dass die zweite Halbleiterschicht gleichzeitig auf der ersten Halbleiterschicht und auf einem lateral dazu angeordneten Kontakt abgeschieden wird. Dies hat den Vorteil eines schnellen und einfachen Schichtens der organischen Halbleiter ohne etwaige Zwischen- oder Strukturierungsschritte.

In einer vorteilhaften Ausgestaltung der Erfindung umfasst das Herstellungsverfahren die Herstellung einer organischen Leuchtdiode mit einem stromgesteuerten Bauelement. Insbesondere kann die organische Leuchtdiode auch mehrere stromgesteuerte Bauelemente umfassen. Vorzugsweise wird eine organische Leuchtdiode hergestellt, die ein stromgesteuertes Bauelement für die Steuerung des Lochstroms und/oder ein stromgesteuertes Bauelement für die Steuerung des Elektronenstroms aufweist. Bei dem Herstellungsverfahren wird zwischen der Anode und der Emitterzone eine Elektronentransportschicht zwischen einer ersten und einer zweiten Lochtransportschicht abgeschieden und/oder es wird zwischen der Emitterzone und der Kathode eine Lochtransportschicht zwischen einer ersten und einer zweiten Elektronentransportschicht abgeschieden. Die Emissionszone umfasst dabei wenigstens einen Emitter. Es wird also auf der Elektronentransportseite ein den Elektronenstrom steuerndes Bauelement und/oder auf der Lochtransportseite ein den Lochstrom steuerndes Bauelement eingefügt. Diese Bauelemente können in der organischen Leuchtdiode insbesondere die Elektronentransport- bzw. Lochtransportschichten ersetzen. Zwischen der Anode und dem stromgesteuerten Bauelement kann sich eine Lochinjektionsschicht befinden. Analog kann sich zwischen der Kathode und dem stromgesteuerten Bauelement eine Elektroneninjektionsschicht befinden. Zwischen dem stromgesteuerten Bauelement für die Steuerung des Elektronenstroms und der Emitterzone kann sich noch eine Lochblockschicht befinden. Das erfindungsgemäße stromgesteuerte Bauelement kann auch als Stromdrosselelement oder Strombeschränkungselement verstanden werden. Insbesondere ist das Bauelement nicht nur stromgesteuert, sondern es steuert auch den Strom. Das Bauelement ist geeignet den Strom einer Ladungsträgersorte zu kontrollieren. Beispielsweise wird also bei der Herstellung eines solchen Bauelements wenigstens eine Zwischenschicht in eine Elektronen- oder eine Lochtransportschicht eingebracht, die deren Ladungsträger nicht leitet. D.h., es wird zunächst eine Drosselschicht eingefügt. Diese Drosselschicht ist nun aber keine statische Barriere für eine Ladungsträgersorte sondern ist elektrisch veränderbar. Diese elektrische Veränderung wird durch Anlegen einer Spannung an diese Zwischenschicht bewirkt, was die Drosselschicht zur Modulationsschicht macht.

Die prinzipielle Funktionsweise eines stromgesteuerten Bauelements gemäß der Erfindung wird zunächst anhand eines Bauelements für die Lochtransportsteuerung erklärt. Wird an die erste und zweite Lochtransportschicht also an die äußeren Schichten des Bauteils eine Spannung angelegt, welche die Löcher von der ersten in die zweite Lochtransportschicht transportieren soll, kommt es in der Elektronentransportschicht zu einem Überschuss an Löchern. Diese sind in der Elektronentransportschicht die Minoritätsladungsträger und werden deutlich schlechter geleitet als in den Lochtransportschichten. Dadurch entsteht ein Ladungsträgerstau. Durch den Überschuss, d.h. die Ansammlung der Löcher in der Elektronentransportschicht entsteht ein Konzentrationsgradient der Ladungsträger im Bauteil. Aufgrund dieses Ladungsträgerkonzentrationsgradienten fließt ein Diffusionsstrom, so dass die Löcher weiter zum zweiten Lochtransporter geleitet werden. Die in der ersten Lochtransportschicht injizierten Löcher werden dabei in dem starken elektrischen Feld des Elektronentransporters beschleunigt.

Vorzugsweise weist die erste Lochtransportschicht eine hohe Dotierung auf. Diese liegt insbesondere zwischen 0,01 Vol-% und 10 Vol-%. Die Dotierkonzentration liegt aber höchstens bei 20 Vol-%, allerhöchstens bei 50 Vol-%. Es werden freie Ladungsträgerkonzentrationen im Bereich von $10^{15}/cm^3$ bis $10^{19}/cm^3$ erhalten. Auch die Modulationsschicht, d.h. die Elektronentransportschicht zwischen den Lochtransportschichten kann eine Dotierung aufweisen. Diese liegt insbesondere im gleichen Konzentrationsbereich wie die des Lochtransporters.

Zweckdienlich ist die Ausgestaltung des Bauelements mit einer Modulationsschicht z.B. einer Elektronentransportschicht zwischen zwei Lochtransportschichten, deren Schichtdicke geringer ist als die Diffusionslänge der Minoritätsladungsträger in der Modulationsschicht, insbesondere also der Löcher in der Elektronentransportschicht. Die geringe Dicke der Modulationsschicht hat den zusätzlichen Vorteil, dass sie ein organisches Bauteil in das das Bauelement zur Loch- oder Elektronenmodulation eingebracht wird, nicht wesentlich verdickt. Beispielsweise bei einem Einsatz in organischen Leuchtdioden, die üblicherweise Elektronen oder Lochtransportschichten im Bereich von 1 nm bis 10000 nm aufweisen, tragen die Modulationsschichten nicht zu einer wesentlich höheren Bauteildicke bei. Insbesondere wenn die Transportschichten dotiert sind, wird die über das gesamte Bauteil abfallende Spannung nur unwesentlich erhöht. Somit bleibt die Effizienz der organischen Leuchtdiode erhalten.

Zur Einstellung oder Steuerung eines Elektronenstroms kann ein erfindungsgemäßes stromgesteuertes Bauelement mit zwei Elektronentransportschichten und einer dazwischen angeordneten Lochtransportschicht verwendet werden. Zwischen den Halbleiterschichten sind wiederum Heteroübergänge ausgebildet. Bei Anlegen einer äußeren Spannung an die beiden Elektronentransportschichten soll ein Elektronentransport von der ersten in die zweite Elektronentransportschicht erfolgen. Dieser wird durch die Existenz der dazwischen angeordneten Lochtransportschicht vermindert oder verhindert. Durch Anlegen der Modulationsspannung an den ersten Elektronentransporter und die Lochtransportschicht, also die Modulationsschicht, fließen Elektronen von dem ersten Lochtransporter über die Lochtransportschicht ab. Somit wird die Elektronenbarriere, die sich in der Lochtransportschicht ausbildet, verringert und ein erhöhter Elektronenstrom fließt von dem ersten in den zweiten Elektronentransporter. Um eine möglichst gute Leitfähigkeit des Elektronenstroms zu gewährleisten muss vor allem in der ersten Elektronentransportschicht auf hohe Ladungsträgerdichten geachtet werden, die z.B. über eine geeignet hohe Dotierung der Schicht gewährleistet werden. Die Dotierkonzentration der ersten Elektronentransportschicht beträgt insbesondere zwischen 0,01 Vol-% und 10 Vol-%. Die Dotierkonzentration beträgt aber höchstens 50 Vol-%. Vorzugsweise beträgt die Dotierkonzentration weniger als 20 Vol-%. Um zu verhindern, dass eine Rekombination in der Lochtransportschicht, die als Modulationsschicht dient, stattfindet, wird die Dicke der Lochtransportschicht zweckdienlicherweise so gewählt, dass sie geringer als die Diffusionslänge der Elektronen in dem Lochtransportmaterial ist. Auch die Lochtransport- bzw. Modulationsschicht ist vorzugsweise hoch dotiert. Insbesondere liegt in der Modulationsschicht eine Dotierkonzentration zwischen 0,01 Vol-% und 10 Vol-% vor.

Ohne angelegte Modulationsspannung bildet im Feld der Bauteilbetriebsspannung die Modulationsschicht eine Drossel- oder Sperrschicht. Diese Modulationsschicht, eingebracht in die Transportschichten, verhindert den Ladungstransport. Dies liegt insbesondere daran, dass sich die Ladungsträger in der Modulationsschicht, die nicht für deren Transport geeignet ist, ansammeln und aufstauen. Dieses Aufstauen der Ladungsträger in der Drosselschicht kann durch Anlegen der Modulationsspannung bzw. durch den dadurch erzeugten Modulationsstrom verhindert, bzw. vermindert werden. Die Ladungsträger werden insbesondere durch die Modulationsspannung über die Modulationsschicht abfließen und begünstigen so den Stromfluss von der ersten in die zweite Transportschicht über die jeweilige Modulationsschicht. Der Modulationsstrom steuert also den Stromfluss durch das Bauteil.

Ausführungsformen der vorliegenden Erfindung sind in exemplarischer Weise mit Bezug auf die Figuren 1 bis 5 beschrieben:

Figur 1    zeigt einen Lochmodulator,
Figur 2    zeigt einen Elektronenmodulator,
Figur 3    zeigt ein Diagramm mit Auftragung der Schichtdicke und Diffusionslänge,
Figur 4    zeigt eine organische Leuchtdiode mit einem Lochmodulator,
Figur 5    zeigt eine organische Leuchtdiode mit einem Elektronenmodulator
           und
Figur 6    zeigt eine organische Leuchtdiode mit einem Elektronen- und einem Lochmodulator.

Alle Figuren sind rein schematisch und stellen keine maßstabsgetreuen Abbildungen dar.

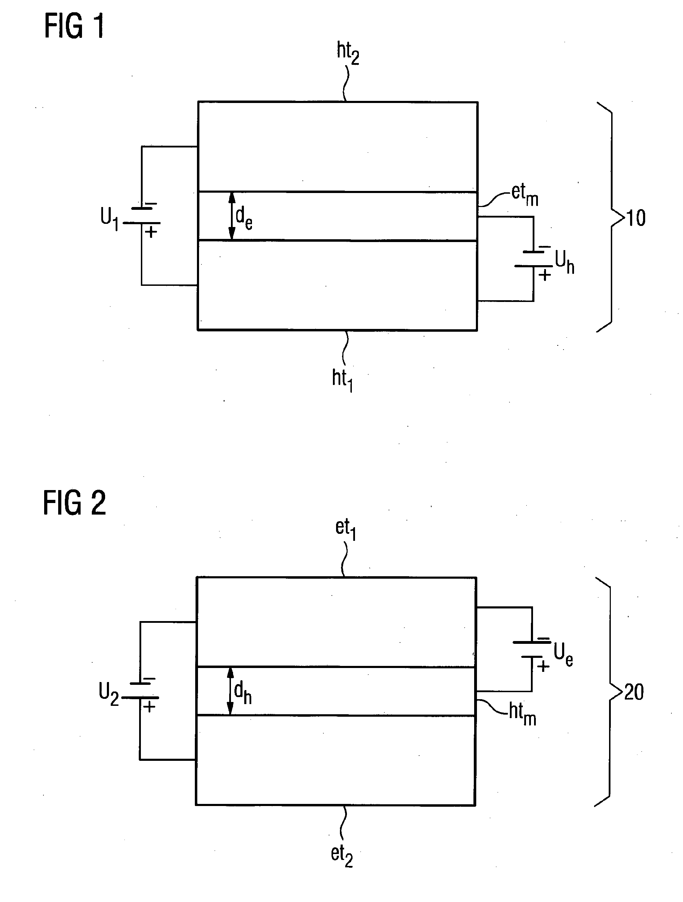

Der in Figur 1 gezeigte Lochmodulator 10 besteht aus drei organischen Halbleiterschichten, die übereinander angeordnet sind. Für die Herstellung eines solchen Dreischichtsystems wird auf eine erste Schicht, die ein Lochtransporter $ht_1$ ist, eine zweite Schicht, die eine Elektronentransportschicht $et_m$ ist und eine dritte Schicht, die eine Lochtrans-

portschicht ht$_2$ ist, abgeschieden. Es befindet sich also zwischen zwei Lochtransportschichten ht$_1$, ht$_2$ eine Elektronentransportschicht et$_m$. Diese Elektronentransportschicht et$_m$ stellt die Modulationsschicht dar. Die drei organischen Halbleiterschichten sind jeweils kontaktierbar. Die erste Lochtransportschicht ht$_1$ ist über eine Spannungsquelle U$_1$ mit der zweiten Lochtransportschicht ht$_2$ verbunden. Über die Spannungsversorgung U$_1$ kann an die beiden äußeren Lochtransportschichten ht$_1$, ht$_2$ eine Spannung U$_1$ angelegt werden. Die Spannung U$_1$ wird so angelegt, dass ein Lochtransport von der ersten Lochtransportschicht ht$_1$ durch die Modulatorschicht et$_m$ in die zweite Lochtransportschicht ht$_2$ erfolgt. Die erste Lochtransportschicht ht$_1$ ist über einen weiteren Kontakt mit einer zweiten Spannungsquelle U$_h$ und darüber mit der Elektronentransportschicht et$_m$ verbunden. Es wird also an die Elektronentransport- bzw. Modulatorschicht et$_m$ und die erste Lochtransportschicht ht$_1$ eine weitere Spannung U$_h$ angelegt.

Die Elektronentransportschicht et$_m$ ist eine hochdotierte n-leitende Schicht. Über diese Modulatorschicht et$_m$ wird der Lochstrom vom ersten Lochtransporter ht$_1$ zum zweiten Lochtransporter ht$_2$ beeinflusst. Infolge des Überschusses an Löchern in der Elektronentransportschicht et$_m$, wo diese Minoritätsladungsträger sind, und des damit verbundenen Konzentrationsgradienten fließt ein Diffusionsstrom, so dass die Löcher zum zweiten Lochtransporter ht$_2$ transportiert werden. Die in der ersten Lochtransportschicht ht$_1$ injizierten Löcher werden dabei in dem starken elektrischen Feld des Elektronentransporters et$_m$ beschleunigt. Der erste Lochtransporter ht$_1$ ist vorzugsweise hochdotiert, so dass eine hohe Lochleitfähigkeit besteht. Dadurch verbessert sich die Eigenschaft des Lochmodulators zur Modulation des Lochstroms. Die Zahl der freien Ladungsträger in einem undotierten organischen Transportmaterial ist meist sehr gering und liegt im Bereich von $10^5$ bis $10^9$/cm$^3$. Die Dotierung wird so gewählt, dass die Zahl der freien Ladungsträger um bis zum 10 Größenordnungen auf einen Bereich von $10^{15}$ bis $10^{19}$/cm$^3$ erhöht wird. Dafür werden Dotierstoffkonzentrationen im Bereich von 0,01 Vol-% bis 50 Vol-% eingesetzt.

Die Dicke d$_e$ der Elektronentransport- bzw. Modulatorschicht et$_m$ muss kleiner sein als die Diffusionslänge L$_{diff}$ der Minoritätsladungsträger, die in diesem Fall Löcher sind. Die Diffusionslänge L$_{diff}$ kann aus der Ladungsträgerbeweglichkeit µ und der Lebensdauer $\tau$ der freien Ladungsträger bestimmt werden.

Beispielsweise ist das Elektronentransportmaterial Alq (tris(8-hydroxyquinolinato)aluminum). Die feldabhängige Lochbeweglichkeit µ$_h$ in Alq beträgt

$$\mu_h(Alq) = 1.2 \cdot 10^{-7} \frac{cm^2}{V \cdot s} \cdot \exp\left(\sqrt{\frac{U_h/d_e}{1959 kV/cm}}\right)$$

Unter der Annahme einer Lebensdauer $\tau$ der freien Ladungsträger von 50 ns, ergibt sich für die Schichtdicke d$_e$ einer Alq-Modulatorschicht ein Maximalwert von 10 nm. Dieser Wert berechnet sich aus der Lochmobilität µ$_h$ in dem Alq, aus der Lebensdauer $\tau$ der Ladungsträger sowie aus dem elektrischen Feld, welches direkt proportional zur angelegten Modulatorspannung U$_h$ ist.

In der Figur 2 ist ein Elektronenmodulator gezeigt. Dieser ist wiederum aus drei organischen Halbleiterschichten aufgebaut. Die organischen Halbleiterschichten sind vertikal übereinander angeordnet, so dass der Stromfluss vertikal durch das Bauteil führt. Über einer zweiten Elektronentransportschicht et$_2$ ist eine Lochtransportschicht ht$_m$ angeordnet. Darüber wiederum ist eine erste Elektronentransportschicht et$_1$ angeordnet. Die drei Schichten liegen so übereinander, dass jeweils ein großflächiger Kontakt von der Elektronentransportschicht zur Lochtransportschicht hergestellt wird. Die Lochtransportschicht ht$_m$ ist in ihrer Schichtdicke d$_u$ wesentlich geringer als die Elektronentransportschichten et$_1$,et$_2$. Die Lochtransportschicht ht$_m$ stellt die Modulationsschicht für den Elektronenfluss dar. An den zwei äußeren Elektronentransportschichten et$_1$, et$_2$ wird eine Spannung U$_2$ so angelegt, dass ein Elektronenfluss von dem ersten Elektronentransporter et$_1$ zu dem zweiten Elektronentransporter et$_2$ hin erfolgt, d.h. durch die Lochtransportschicht ht$_m$. Diese stellt jedoch zunächst eine Barriere dar. Die Elektronentransportschicht et$_1$ ist mit einem weiteren Kontakt versehen, so dass eine Spannung U$_e$ zwischen der ersten Elektronentransportschicht et$_1$ und der Lochtransportmodulatorschicht ht$_m$ angelegt werden kann. Die Spannung wird so angelegt, dass ein Elektronenfluss von dem ersten Elektronentransporter et$_1$ über den Lochtransporter ht$_m$ erfolgt. Mit Erhöhen der Spannung U$_e$ nimmt die Barriereeigenschaft der Modulatorschicht ht$_m$ ab. Über den Stromfluss von dem ersten Elektronentransporter et$_1$ über den Lochtransporter ht$_m$ kann somit der Gesamtstromfluss von dem ersten Elektronentransporter et$_1$ bis hin zum zweiten Elektronentransporter et$_2$ gesteuert werden.

Ein Elektronenmodulatoraufbau erfolgt also analog zum Lochmodulatoraufbau in vertikale Anordnung eines Dreischichtsystems von zwei Elektronentransportschichten et$_1$,et$_2$ und einer dazwischen angeordneten Lochtransportschicht ht$_m$. Um möglichst gute Eigenschaften der Elektronenmodulatorschicht ht$_m$ zu gewährleisten, muss eine hohe Ladungsträgerdichte in der Elektronentransportschicht beachtet werden. Dazu ist vor allem die zweite Elektronentransportschicht et$_2$ hoch dotiert. Um eine Rekombination von Ladungsträgern in der Lochtransportschicht ht$_m$, also der Modulatorschicht des Elektronenmodulators zu verhindern, muss die Schichtdicke d$_h$ der Modulatorschicht wieder so gering werden, dass sie die Diffusionslänge L$_{diff}$ der Elektronen im Material, d.h. der Minoritätsladungsträger in der Modulatorschicht nicht übersteigt. Häufig gehen dabei hohe Ladungsträgerbeweglichkeiten µ mit hohen Diffusionslängen L$_{diff}$ einher.

Ein Beispiel für einen Lochleiter, der als Modulatorschicht in dem Elektronenmodulator eingesetzt werden kann, ist α-NPD (N,N'-di(naphthalen-1-yl)-N, N'-diphenylbenzidine). Die feldabhängige Elektronenbeweglichkeit μ$_e$ in α-NPD beträgt

$$\mu_e(\alpha - NPD) = 6.1 \cdot 10^{-6}\, \frac{cm^2}{V \cdot s} \cdot \exp(\sqrt{\frac{U_e/d_h}{1500 kV/cm}})$$

Die maximale Schichtdicke für diese Lochtransportschicht berechnet sich aus der Elektronenbeweglichkeit μ$_e$ und Lebensdauer τ sowie aus dem angelegten Feld, das direkt proportional zur Modulatorspannung U$_e$ ist. Wird wiederum eine Lebensdauer τ der freien Ladungsträger von 50 ns angenommen, errechnet sich der maximale Wert für die Schichtdicke d$_h$ der Modulatorschicht auf 100 nm.

Beispiele für Elektronentransportmaterialien sind:

- 2,2',2"-(1,3,5-Benzenetriyl)-tris(1-phenyl-1-H-benzimidazole)
- 2-(4-Biphenylyl)-5-(4-tert-butylphenyl)-1,3,4-oxadiazole
- 2,9-Dimethyl-4,7-diphenyl-1,10-phenanthroline
- 8-Hydroxyquinolinolato-lithium
- 4-(Naphthalen-1-yl)-3,5-diphenyl-4H-1,2,4-triazole
- 1,3-Bis[2-(2,2'-bipyridine-6-yl)-1,3,4-oxadiazo-5-yl]benzene
- 4,7-Diphenyl-1,10-phenanthroline
- 3-(4-Biphenylyl)-4-phenyl-5-tert-butylphenyl-1,2,4-triazole
- Bis(2-methyl-8-quinolinolate)-4-(phenylphenolato)aluminium
- 6,6'-Bis[5-(biphenyl-4-yl)-1,3,4-oxadiazo-2-yl]-2,2'-bipyridyl
- 2-phenyl-9,10-di(naphthalen-2-yl)-anthracene
- 2,7-Bis[2-(2,2'-bipyridine-6-yl)-1,3,4-oxadiazo-5-yl]-9,9-dimethylfluorene
- 1,3-Bis[2-(4-tert-butylphenyl)-1,3,4-oxadiazo-5-yl]benzene
- 2-(naphthalen-2-yl)-4,7-diphenyl-1,10-phenanthroline
- 2,9-Bis(naphthalen-2-yl)-4,7-diphenyl-1,10-phenanthroline
- Tris(2,4,6-trimethyl-3-(pyridin-3-yl)phenyl)borane
- 1-methyl-2-(4-(naphthalen-2-yl)phenyl)-1H-imidazo[4,5f][1,10]phenanthroline

Um die Elektronenleitfähigkeit dieser Elektronentransportmaterialien zu erhöhen, können diese dotiert sein.

Beispiele für Dotierstoffe sind:

- Alkalimetalle, Erdalkalimetalle, Lanthodoide wie Li, Na, K, Cs, Ca, Mg, Sr, Ba oder Sm
- Anorganische Salze, die die Elektronenleitfähigkeit erhöhen: Cs$_2$CO$_3$
- Stark reduzierend wirkende metallorganische Komplexe wie W$_2$(TBD)$_4$, Mo$_2$(TBD)$_4$, wobei TBD das Anion des 1,5,7-Triazabicyclo[4.4.0]dec-5-ene ist, oder
- Metall (0) komplexe wie Mo(CO)$_6$ oder W(CO)$_6$.

Beispiele für Lochtransportmaterialien sind:

- N,N'-Bis(naphthalen-1-yl)-N,N'-bis(phenyl)-9,9-dimethylfluorene
- N,N'-Bis(3-methylphenyl)-N,N'-bis(phenyl)-9,9-diphenyl-fluorene
- N,N'-Bis(naphthalen-1-yl)-N,N'-bis(phenyl)-9,9-diphenyl-fluorene
- N,N'-Bis(naphthalen-1-yl)-N,N'-bis(phenyl)-2,2-dimethylbenzidine
- N,N'-Bis(3-methylphenyl)-N,N'-bis(phenyl)-9,9-spirobifluorene
- 2,2',7,7'-Tetrakis(N,N-diphenylamino)-9,9'-spirobifluorene
- N,N'-Bis(naphthalen-1-yl)-N,N'-bis(phenyl)-benzidine
- N,N'-Bis(naphthalen-2-yl)-N,N'-bis(phenyl)-benzidine
- N,N'-Bis(3-methylphenyl)-N,N'-bis(phenyl)-benzidine
- N,N'-Bis(3-methylphenyl)-N,N'-bis(phenyl)-9,9-dimethylfluorene
- N,N'-Bis(naphthalen-1-yl)-N,N'-bis(phenyl)-9,9-spirobifluorene
- Di-[4-(N,N-ditolyl-amino)-phenyl]cyclohexane
- 2,2',7,7'-tetra(N, N-di-tolyl)amino-spiro-bifluorene
- 9,9-Bis[4-(N,N-bis-biphenyl-4-yl-amino)phenyl]-9H-fluorene

- 2,2',7,7'-Tetrakis[N-naphthalenyl(phenyl)-amino]-9,9-spirobifluorene
- 2,7-Bis[N,N-bis(9,9-spiro-bifluorene-2-yl)-amino]-9,9-spirobifluorene
- 2,2'-Bis[N,N-bis(biphenyl-4-yl)amino]-9,9-spirobifluorene
- N,N'-bis(phenanthren-9-yl)-N,N'-bis(phenyl)-benzidine
- N,N,N',N'-tetra-naphthalen-2-yl-benzidine
- 2,2'-Bis(N,N-di-phenyl-amino)-9,9-spirobifluorene
- 9,9-Bis[4-(N,N-bis-naphthalen-2-yl-amino)phenyl]-9H-fluorene
- 9,9-Bis[4-(N,N'-bis-naphthalen-2-yl-N,N'-bis-phenyl-amino)-phenyl]-9H-fluorene
- Titanium oxide phthalocyanine
- Copper phthalocyanine
- 2,3,5,6-Tetrafluoro-7,7,8,8,-tetracyano-quinodimethane
- 4,4',4"-Tris(N-3-methylphenyl-N-phenyl-amino)triphenylamine
- 4,4',4"-Tris(N-(2-naph,thyl)-N-phenyl-amino)triphenylamine
- 4,4',4"-Tris(N-(1-naphthyl)-N-phenyl-amino)triphenylamine
- 4,4',4"-Tris(N,N-diphenyl-amino)triphenylamine
- Pyrazino[2,3-f][1,10]phenanthroline-2,3-dicarbonitrile
- N, N,N',N'-Tetrakis(4-methoxyphenyl)benzidine
- 2,7-Bis[N,N-bis(4-methoxy-phenyl)amino]-9,9-spirobifluorene
- 2,2'-Bis[N,N-bis(4-methoxy-phenyl)amino]-9,9-spirobifluorene
- N,N'-di(naphthalen-2-yl)-N,N'-diphenylbenzene-1,4-diamine
- N,N'-di-phenyl-N,N'-di-[4-(N,N-di-tolyl-amino)phenyl]benzidine
- N,N'-di-phenyl-N,N'-di-[4-(N,N-di-phenyl-amino)phenyl]benzidine

Zusätzlich sind aber metallorganische Komplexe, wie Tris(phenylpyridinato)iridium(III) oder verwandte Verbindungen als Lochtransportmaterialien geeignet.

Um die Lochleitfähigkeit dieser Lochtransportmaterialien zu erhöhen, können diese dotiert sein. Beispiele für Dotierstoffe sind:

- Anorganische Salze oder Oxide, die die Lochleitfähigkeit erhöhen: $MoO_3$, $WO_3$, $Re_2O_7$, $FeCl_3$,
- Stark Lewissäure-wirkende metallorganische Komplexe wie $Rh_2(O_2CCF_3)_4$, oder Ru-analoge Verbindungen,
- Organische Akzeptormoleküle wie $F_4$-TCNQ.

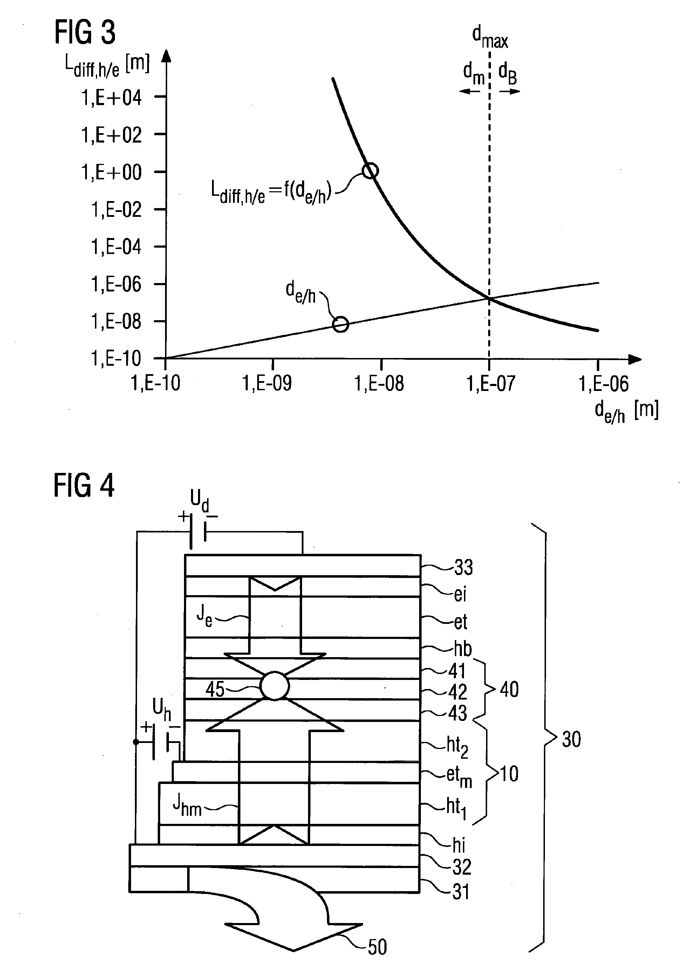

Figur 3 zeigt ein Diagramm, welches die Kalkulation der maximalen Schichtdicke $d_{max}$ der Modulatorschicht $et_m$,$ht_m$ verdeutlicht. Auf der Abszisse ist die Schichtdicke $d_{e/h}$ der Modulatorschicht $et_m$,$ht_m$ aufgetragen. Die Modulatorschichtdicken $d_{e/h}$ betragen zwischen $1 \times 10^{-10}$m und $1 \times 10^{-6}$m. Auf der Ordinate ist die Diffusionslänge $l_{diff}$ der Minoritätsladungsträger in der Modulatorschicht $et_m$,$ht_m$ aufgetragen. Die Diffusionslänge $l_{diff}$ der Minoritätsladungsträger beträgt zwischen $1 \times 10^{-10}$m und $1 \times 10^4$m. In dem Diagramm sind zunächst die Modulatorschichtdickenwerte $d_{e/h}$ aufgetragen. Dazu wurden die Diffusionslängen $l_{diff}$ der Minoritätsladungsträger in Abhängigkeit von der Schichtdicke $d_{e/h}$ der Modulatorschicht $et_m$/$ht_m$ aufgetragen. Die Abhängigkeit von der Schichtdicke $d_{e/h}$ ergibt sich durch die Feldabhängigkeit der Diffusionslänge $l_{diff}$ bzw. der Ladungsträgerbeweglichkeit $\mu$.

Die maximale Schichtdicke $d_{max}$ einer Modulatorschicht $et_m$,$ht_m$ ist im Diagramm mit einer gestrichelten Linie und $d_{max}$ gekennzeichnet. Für kleinere Schichtdicken als $d_{max}$ kann ein funktionsfähiger Ladungsträgermodulator realisiert werden. Für Schichtdicken $d_B$, die oberhalb von $d_{max}$ liegen, bildet die Elektronen- oder Lochtransportschicht innerhalb der Loch- bzw. Elektronentransportschichten eine Barrierenschicht, die unabhängig von einer angelegten Spannung eine Ladungsbarriere darstellt und den Ladungsfluss drosselt bzw. reduziert.

In der Figur 4 ist ein schematischer Aufbau einer organischen Leuchtdiode 30 mit einem Lochmodulator 10 gezeigt. Der Schichtenstapel zeigt von unten nach oben zunächst ein Substrat 31, das beispielsweise ein Glassubstrat ist. Auf dem Glassubstrat 31 ist eine Anode 32 aufgebracht. Die Anode ist vorzugsweise transparent, beispielsweise aus Indiumzinnoxid.

Durch die transparente Anode 32 auf dem Glassubstrat 31 kann das in der organischen Leuchtdiode 30 erzeugte Licht aus dem Bauteil ausgekoppelt werden. Die Lichtauskopplung 50 ist mit einem Pfeil angezeigt. Auf der Anode 32 ist eine Lochinjektionsschicht $h_i$ aufgebracht. Darauf befindet sich ein Lochmodulator 10, d.h. eine erste Lochtransportschicht $ht_1$, darauf eine Elektronentransportschicht $et_m$ und wiederum darauf eine zweite Lochtransportschicht $ht_2$. Die Modulatorspannung $U_h$ ist an der Elektronentransportschicht $et_m$ und an der Anode 32 angelegt. Über dem Lochmodulator 10 folgt der Emissionsbereich 40. Der Emissionsbereich 40 kann aus mehreren Emitterschichten bestehen. Beispielsweise folgen auf den Lochtransportern $ht_2$ eine rote Emissionsschicht 43, eine grüne Emissionsschicht 42 und darauf eine blaue Emissionsschicht 41. In diesem Emissionsbereich 40 kommt es vorzugsweise zu Rekombination 45 der Ladungsträger. Die Rekombinationszone 45 ist durch den Loch- und Elektronenstrom verschiebbar. Es können also je nach dem Verhältnis von Elektronen zu Löchern, die die Emissionszone 40 erreichen, vermehrt Rekombinationen in einer der Emitterschichten 41-43 stattfinden. Oberhalb der Emitterschichten 41-43 folgt beispielsweise ein Lochblocker hb. Darauf ist eine Elektronentransportschicht $et_m$ abgeschieden. Darauf ist eine Elektroneninjektionsschicht $e_i$ angebracht. Darüber befindet sich eine Kathode 33. An die Kathode 33 und Anode 32 ist eine Spannung $U_d$ angelegt, mit der das Bauteil betrieben wird. Die Spannung $U_d$ ist so angelegt, dass an der Kathode 33 Elektronen in das Bauteil injiziert werden und an der Anode 32 Löcher in das Bauteil injiziert werden. Der Elektronenstrom $I_e$ durch die Injektions- und Elektronentransportschicht $e_i$, $e_t$ in die Emitterschichten 41-43 ist durch einen Pfeil von der Kathode 33 Richtung Rekombinationszentrum 45 gekennzeichnet. Der Lochstrom $I_h$ ist analog mit einem Pfeil von der Anode 32 durch die Lochmodulatorschichten 10 bis hin in die Rekombinationszone 45 gekennzeichnet. Der Lochstrom $I_h$, der die Rekombinationszone 45 erreicht, ist über den Lochmodulator 10 einstellbar.

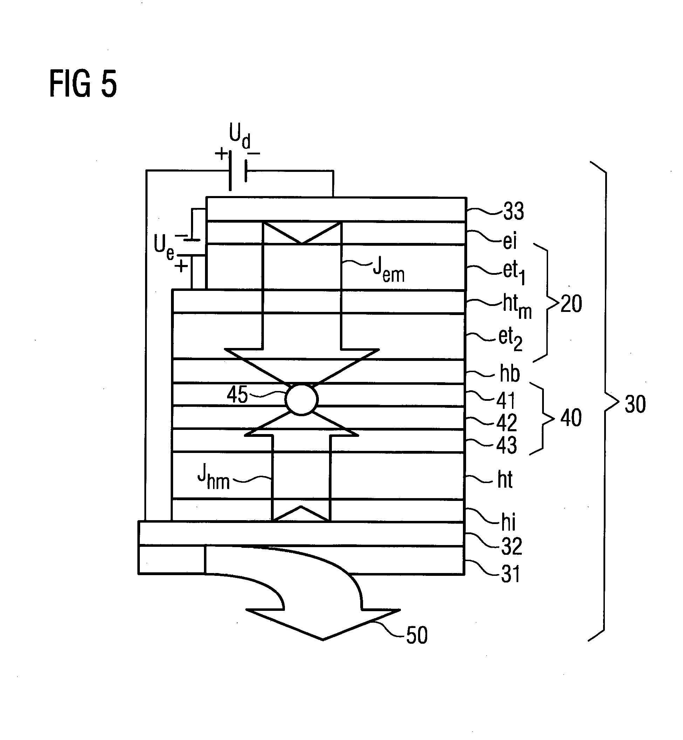

In Figur 5 ist wiederum eine organische Leuchtdiode 30 gezeigt. Diese enthält wieder einen Schichtstapel von organischen Halbleiterschichten, die sich zwischen einer Kathode 33 und einer Anode 32 auf einem Glassubstrat 31 befinden. Ein Pfeil zeigt wieder die Lichtauskopplung 50 durch die transparente Anode 32 und das transparente Substrat 31 an. Auf diesem Substrat 31 und der Anode 32 folgen die organischen Schichten: Zunächst eine Lochinjektionsschicht $h_i$, darauf ein Lochtransporter ht. Darauf folgt der Emissionsbereich 40 mit z.B. drei Emitterschichten 43, 42, 41. Über den Emitterschichten 41-43 ist z.B. ein Lochblocker hb angeordnet. Über dem Lochblocker befindet sich der Elektronentransportbereich. Dieser ist ein Elektronenmodulator 20. D.h. auf der Lochblockerschicht hb ist zunächst ein zweiter Elektronentransporter $et_2$ darauf ein Lochtransporter $Ut_m$ zur Modulation der Elektronen und darauf ein erster Elektronentransporter $et_1$ angeordnet. Über dem Elektronenmodulator 20 befindet sich noch eine Elektroneninjektionsschicht ei unterhalb der Kathode 33. An die Kathode 33 und Anode 32 ist wiederum die Bauteilspannung $U_d$ angelegt. Diese Spannung $U_t$ ist so angelegt, dass ein Elektronenfluss $I_e$ von der Kathode 33 in die organische Leuchtdiode stattfindet und ein Lochtransport $I_u$ von der Anode 32 in die organische Leuchtdiode stattfindet. An die Kathode 33 und die Lochtransportmodulatorschicht $ht_m$ ist die Modulatorspannung $U_e$ angelegt. Diese ist richtungsmäßig so angelegt, dass Elektronen von der Kathode 33 durch die Elektroneninjektionsschicht $e_i$ und die erste Elektronentransportschicht $et_1$ in den Lochtransporter $ht_m$ stattfindet. Durch Anlegen der Spannung $U_e$ wird die Barriereeigenschaft des Lochtransporters $ht_m$ innerhalb der Elektronentransportschichten $et_1/et_2$ vermindert und so der Elektronenstromfluss $I_e$ erhöht. Der so modulierte Elektroneninjektionsstrom $I_e$ ist durch einen Pfeil von der Kathode 33 in Richtung der Emissionsschichten 40 angedeutet. Der Lochtransport $I_u$ erfolgt von der Anode 32 in Richtung der Emissionsschichten 40 und ist auch durch einen Pfeil angezeigt. Wo Elektronen und Löcher aufeinandertreffen, kann die Rekombination 45 der Ladungsträger stattfinden. Dieser Ort ist durch das Verhältnis von Elektronen zu Löchern beeinflussbar. Durch die Elektronenmodulation kann die Rekombinationszone 45 innerhalb des Emissionsbereichs 40 in die unterschiedlichen Emissionsschichten 41-43 geschoben werden.

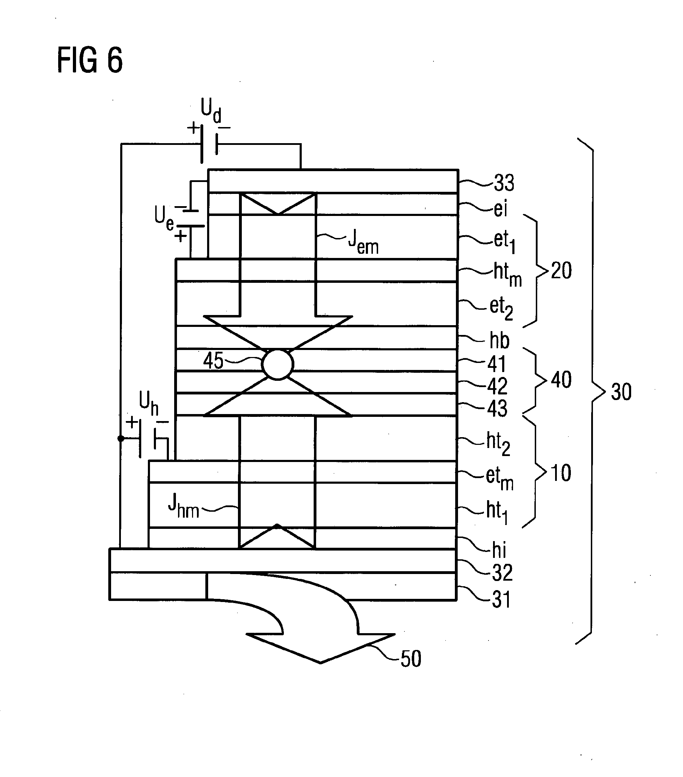

In Figur 6 schließlich ist wieder eine organische Leuchtdiode 30 mit einem Elektronenmodulator 20 und einem Lochmodulator 10 gezeigt. D.h. der Schichtstapel von organischen Halbleiterschichten umfasst einen Lochmodulator 10, einen Elektronenmodulator 20 und ein Emissionsschichtensystem 40. Der Lochmodulator ist wiederum auf einer Lochinjektionsschicht $h_i$ und diese wiederum auf einer Anode 32 auf einem Glassubstrat 31 aufgebracht. Über dem Lochmodulator 10 befinden sich die Emissionsschichten 40, darüber ein Lochblocker hb und darüber befindet sich der Elektronenmodulator 20. Die Elektroneninjektion von der Kathode 33 in die organische Leuchtdiode erfolgt über eine Elektroneninjektionsschicht $e_i$, die zwischen Kathode 33 und Elektronenmodulator 20 angeordnet ist. Um die Ladungsträger zu modulieren wird an die Kathode 33 und die Anode 32 die Bauteilspannung $U_d$ angelegt und zusätzlich zwischen der Elektronentransportschicht $et_m$ des Lochmodulators 10 die Lochmodulationsspannung $U_d$ und zusätzlich an der Lochtransportschicht $ht_m$ des Elektronenmodulators 20 die Elektronenmodulationsspannung $U_e$. In der organischen Leuchtdiode 30 können auf der Kathodenseite Lochblocker hb und auf der Anodenseite Elektronenblocker eingebracht sein, um die einzelnen Ladungsträger gezielt in die emittierende Schicht 40 einzusperren.

**Patentansprüche**

**1.** Stromgesteuertes Bauelement mit aufeinanderliegenden organischen Halbleiterschichten, wobei

- eine Elektronentransportschicht zwischen einer ersten und einer zweiten Lochtransportschicht und/oder
- eine Lochtransportschicht zwischen einer ersten und einer zweiten Elektronentransportschicht angeordnet ist, **dadurch gekennzeichnet, dass**
- die Elektronentransportschicht zwischen der ersten und der zweiten Lochtransportschicht als eine Modulationsschicht ausgestaltet ist und/oder
- die Lochtransportschicht zwischen der ersten und der zweiten Elektronentransportschicht als eine Modulationsschicht ausgestaltet ist, wobei
- die Modulationsschicht einen Kontakt für eine Modulationsspannung aufweist, mittels derer ein Modulations-

Stromfluss über die Modulationsschicht erzeugbar ist, über welchen der Bauteil-Stromfluss von der ersten in die zweite Lochtransportschicht und/oder Elektronentransportschicht durch die jeweilige Modulationsschicht steuerbar ist.

2. Stromgesteuertes Bauelement nach Anspruch 1, wobei die organischen Halbleiterschichten in einem vertikalen Schichtstapel aufeinanderliegen.

3. Stromgesteuertes Bauelement nach Anspruch 1 oder 2, wobei zwischen den aufeinanderliegenden Halbleiterschichten Heteroübergänge ausgebildet sind oder wobei zwischen den Halbleiterschichten intrinsische Zwischenschichten angeordnet sind.

4. Stromgesteuertes Bauelement nach einem der vorstehenden Ansprüche, wobei die Modulationsschicht eine Schichtdicke aufweist, die geringer ist als die Diffusionslänge der Minoritätsladungsträger in dem Halbleitermaterial der Modulationsschicht.

5. Stromgesteuertes Bauelement nach einem der vorstehenden Ansprüche, wobei die Modulationsspannung so an die Modulationsschicht und die erste Loch- und/oder Elektronentransportschicht anlegbar ist, dass die zu steuernden Ladungsträger, die die Majoritätsladungsträger in dem Halbleitermaterial der Transportschichten und die Minoritätsladungsträger in dem Halbleitermaterial der Modulationsschicht sind, von der ersten Transportschicht in die Modulationsschicht bewegt werden.

6. Stromgesteuertes Bauelement nach einem der vorstehenden Ansprüche mit dotierten Transportschichten, insbesondere mit einer Dotierkonzentration zwischen 0.01 Vol-% und 10 Vol-%.

7. Stromgesteuertes Bauelement nach einem der vorstehenden Ansprüche mit einer dotierten Modulationsschicht, insbesondere mit einer Dotierkonzentration zwischen 0.01 Vol-% und 10 Vol-%.

8. Organische Leuchtdiode mit wenigstens einem stromgesteuerten Bauelement nach einem der Ansprüche 1 bis 7.

9. Organische Leuchtdiode nach Anspruch 8, wobei die Farbwiedergabe der organischen Leuchtdiode durch Anlegen der Modulationsspannung veränderbar ist.

10. Organische Leuchtdiode nach Anspruch 8 oder 9 mit einer Emissionszone aus mindestens zwei Emissionsschichten, insbesondere Emissionsschichten, die Licht unterschiedlicher Farbe emittieren.

11. Organische Leuchtdiode nach einem der Ansprüche 8 bis 10, wobei deren Effizienz durch Anlegen der Modulationsspannung veränderbar ist.

12. Herstellungsverfahren für ein stromgesteuertes Bauelement nach einem der Ansprüche 1 bis 7, bei dem auf eine erste organische Halbleiterschicht zunächst eine zweite und anschließend eine dritte organische Halbleiterschicht vertikal aufeinander abgeschieden werden, wobei für die erste und dritte Halbleiterschicht Materialien mit gleicher Majoritätsladungsträgersorte verwendet werden und für die zweite Halbleiterschicht ein Material mit davon unterschiedlicher Majoritätsladungsträgersorte verwendet wird, **dadurch gekennzeichnet, dass**
mit oder nach der Abscheidung der zweiten Halbleiterschicht eine elektrische Kontaktierung der zweiten Halbleiterschicht mit einem Kontakt vorgenommen wird, der nicht in direkten elektrischen Kontakt mit der dritten Halbleiterschicht gebracht wird, insbesondere indem die zweite Halbleiterschicht durch ein verändertes Schichtlayout gegenüber der ersten und/oder der dritten Halbleiterschicht auf einen lateral angeordneten Kontakt mit abschieden wird.

## Claims

1. Current-controlled component having organic semiconductor layers lying on one another, wherein

   - an electron transport layer is arranged between a first and a second hole transport layer and/or
   - a hole transport layer is arranged between a first and a second electron transport layer
   **characterized in that**
   - the electron transport layer between the first and second hole transport layers is configured as a modulation layer, and/or
- the hole transport layer between the first and second electron transport layers is configured as a modulation layer, wherein
- the modulation layer has a contact for a modulation voltage, by means of which a modulation current across the modulation layer can be generated, by which the component current from the first hole transport layer and/or electron transport layer into the second through the respective modulation layer can be controlled.

2. Current-controlled component according to Claim 1, wherein the organic semiconductor layers lie on one another in a vertical layer stack.

3. Current-controlled component according to Claim 1 or 2, wherein heterojunctions are formed between the semiconductor layers lying on one another, or wherein intrinsic interlayers are arranged between the semiconductor layers.

4. Current-controlled component according to one of the preceding claims, wherein the modulation layer has a thickness which is less than the diffusion length of the minority charge carriers in the semiconductor material of the modulation layer.

5. Current-controlled component according to one of the preceding claims, wherein the modulation voltage can be applied to the modulation layer and to the first hole and/or electron transport layer in such a way that the charge carriers to be controlled, namely the majority charge carriers in the semiconductor material of the transport layers and the minority charge carriers in the semiconductor material of the modulation layer, are moved from the first transport layer into the modulation layer.

6. Current-controlled component according to one of the preceding claims, comprising doped transport layers, in particular having a doping concentration of between 0.01 vol% and 10 vol%.

7. Current-controlled component according to one of the preceding claims, comprising a doped modulation layer, in particular having a doping concentration of between 0.01 vol% and 10 vol%.

8. Organic light-emitting diode comprising at least one current-controlled component according to one of Claims 1 to 7.

9. Organic light-emitting diode according to Claim 8, wherein the color rendering of the organic light-emitting diode can be varied by application of the modulation voltage.

10. Organic light-emitting diode according to Claim 8 or 9, comprising an emission zone consisting of at least two emission layers, in particular emission layers which emit light of different colors.

11. Organic light-emitting diode according to one of Claims 8 to 10, the efficiency of which can be varied by application of the modulation voltage.

12. Production method for a current-controlled component according to one of Claims 1 to 7, in which first a second and subsequently a third organic semiconductor layer are deposited vertically above one another on a first organic semiconductor layer, wherein materials having the same majority charge carrier types are used for the first and third semiconductor layers and a material having a majority charge carrier type different thereto is used for the second semiconductor layer, **characterized in that** electrical contacting of the second semiconductor layer is carried out with or after the deposition of the second semiconductor layer, with a contact which is not brought in direct electrical contact with the third semiconductor layer, in particular by the second semiconductor layer being jointly deposited onto a laterally arranged contact by a modified layer layout in relation to the first and/or third semiconductor layer.

**Revendications**

1. Composant commandé par le courant et ayant des couches semiconductrices organiques superposées, dans lequel

- une couche de transport d'électrons est disposée entre une première et une deuxième couches de transport de trous et/ou
- une couche de transport de trous est disposée entre une première et une deuxième couches de transport d'électrons **caractérisé en ce que**

- la couche de transport d'électrons entre la première et la deuxième couches de transport de trous est conformée en couche de modulation et/ou
- la couche de transport de trous entre la première et la deuxième couches de transport d'électrons est conformée en couche de modulation, dans lequel
- la couche de modulation a un contact pour une tension de modulation, au moyen de laquelle un flux de courant de modulation peut être produit par la couche de modulation, par lequel le flux de courant du composant de la première à la deuxième couches de transport de trous et/ou couches de transport d'électrons peut être commandé par la couche de modulation respective.

2. Composant commandé par le courant suivant la revendication 1, dans lequel les couches semiconductrices organiques sont superposées en un empilement de couches verticales.

3. Composant commandé par le courant suivant la revendication 1 ou 2, dans lequel des hétérojonctions sont formées entre les couches semiconductrices superposées ou des couches intermédiaires intrinsèques sont disposés entre les couches semiconductrices.

4. Composant commandé par le courant suivant l'une des revendications précédentes, dans lequel la couche de modulation a une épaisseur, qui est plus petite que la longueur de diffusion des porteurs de charge minoritaires dans le matériau semiconducteur de la couche de modulation.

5. Composant commandé par le courant suivant l'une des revendications précédentes, dans lequel la tension de modulation peut être appliquée à la couche de modulation et à la première couche de transport de trous et/ou d'électrons, de manière à faire passer, de la première couche de transport à la couche de modulation, les porteurs de charge à commander, qui sont les porteurs de charge majoritaires dans le matériau semiconducteur des couches de transport et les porteurs de charge minoritaires dans le matériau semiconducteur de la couche de modulation.

6. Composant commandé par le courant suivant l'une des revendications précédentes, ayant des couches de transport dopées, ayant notamment une concentration de dopage comprise entre 0,01% en volume et 10% en volume.

7. Composant commandé par le courant suivant l'une des revendications précédentes, ayant une couche de modulation dopée, ayant notamment une concentration de dopage comprise entre 0,01% en volume et 10% en volume.

8. Diode électroluminescente organique ayant au moins un composant commandé par le courant suivant l'une des revendications 1 à 7.

9. Diode électroluminescente organique suivant la revendication 8, dans laquelle la restitution de couleur de la diode électroluminescente organique peut être modifiée par application de la tension de modulation.

10. Diode électroluminescente organique suivant la revendication 8 ou 9, ayant une zone d'émission composée d'au moins deux couches d'émission, notamment des couches d'émission qui émettent de la lumière de couleur différente.

11. Diode électroluminescente suivant l'une des revendications 8 à 10, dont l'efficacité peut être modifiée par application de la tension de modulation.

12. Procédé de fabrication d'un composant commandé par le courant suivant l'une des revendications 1 à 7, dans lequel on dépose verticalement, les unes sur les autres, sur une première couche semiconductrice organique, d'abord une deuxième et ensuite une troisième couche semiconductrice organique, en utilisant, pour la première et la troisième couches semiconductrices, des matières ayant une même sorte de porteurs de charge majoritaires et, pour la deuxième couche semiconductrice, une matière ayant une sorte de porteurs de charge majoritaires, qui en diffère, **caractérisé en ce que**, avec ou après le dépôt de la deuxième couche semiconductrice, on met en contact électrique la deuxième couche semiconductrice avec un contact que l'on ne met pas en contact électrique direct avec la troisième couche semiconductrice, notamment en déposant, sur un contact disposé latéralement, la deuxième couche semiconductrice par une configuration de couche modifiée par rapport à la première et/ou à la troisième couche semiconductrice.

FIG 1

$ht_2$

$U_1$

$d_e$

$et_m$

$U_h$

10

$ht_1$

FIG 2

$et_1$

$U_2$

$d_h$

$U_e$

$ht_m$

20

$et_2$

## FIG 3

## FIG 4

FIG 5

# FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1978574 A
- US 2007096644 A
- EP 1531501 A
- EP 1748505 A